(19)

Europäisches
Patentamt
European
Patent Office
Office européen
des brevets

(11) **EP 2 365 742 A1**

(12) **EUROPEAN PATENT APPLICATION**

(43) Date of publication:
**14.09.2011 Bulletin 2011/37**

(51) Int Cl.:
**H05K 3/40** *(2006.01)*

(21) Application number: **10189078.8**

(22) Date of filing: **27.10.2010**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **10.03.2010 JP 2010052642**

(71) Applicant: **Omron Corporation
Kyoto-shi, Kyoto 600-8530 (JP)**

(72) Inventors:
 • **Doi, Sayaka
  Kyoto-shi, Kyoto 600-8530 (JP)**

 • **Okuno, Toshiaki
  Kyoto-shi, Kyoto 600-8530 (JP)**
 • **Sano, Akihiko
  Kyoto-shi, Kyoto 600-8530 (JP)**
 • **Miyaji, Takaaki
  Kyoto-shi, Kyoto 600-8530 (JP)**
 • **Hada, Yoshiki
  Kyoto-shi, Kyoto 600-8530 (JP)**

(74) Representative: **Wilhelms · Kilian & Partner
Patentanwälte
Eduard-Schmid-Straße 2
81541 München (DE)**

(54) **Electrode portion structure**

(57)    In an electrode portion structure (11A,11B) in which an electrode (13) is formed in an end portion of a through-wiring, disconnection is prevented in an electrode portion. A through-hole (16) that vertically pierces a substrate (12) is made in the substrate (12), and a through-electrode (15) is provided in the through-hole (16). The through-electrode (15) is projected in s curved-surface manner from an upper surface of the substrate (12). The upper surface of the substrate (12) is coated with an insulating film (18), and a contact hole (19) is made in the insulating film (18) while aligned with the through-electrode (15). An opening diameter of the contact hole (19) is lower than a sectional diameter of the through-electrode (15), and surroundings of an upper surface of the through-electrode (15) are coated with the contact hole (19). A thickness Ddiel of the insulating film (18) is equal to or lower than a projection length Dp of the through-electrode (15) from the upper surface of the substrate at an opening edge of the contact hole (19). Additionally, assuming that Dtsv is a projection length (maximum projection length) of an apex of the through-electrode (15) from the upper surface of the substrate, the projection length Dtsv is adjusted so as to become $0 \leq \text{Dtsv} \leq \text{Ddiel} + \text{Dp}$ (Dp > 0).

EP 2 365 742 A1

**Description**

BACKGROUND OF THE INVENTION

1. TECHNICAL FIELD

The present invention relates to an electrode portion structure, specifically to an electrode portion structure in which an electrode is formed in an end portion of through-wiring.

2. RELATED ART

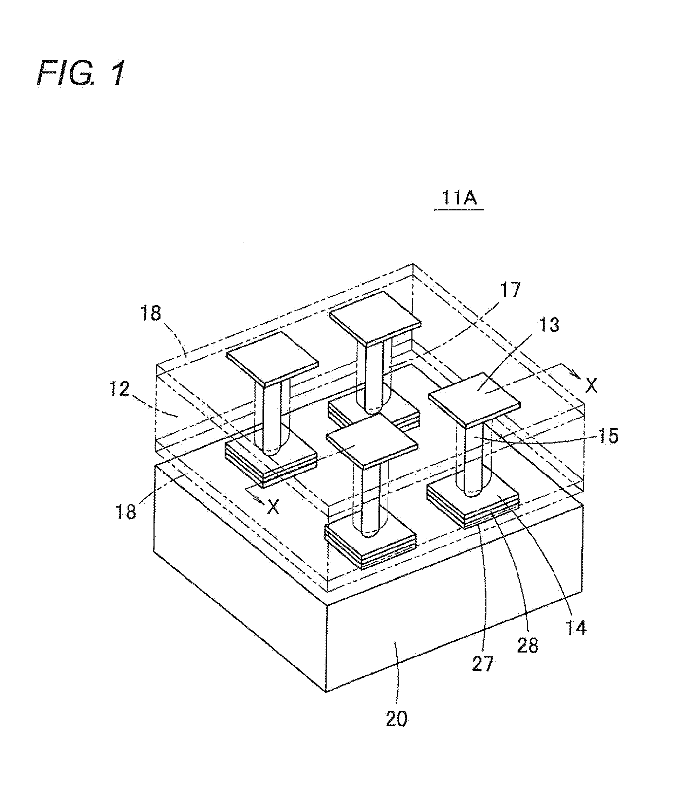

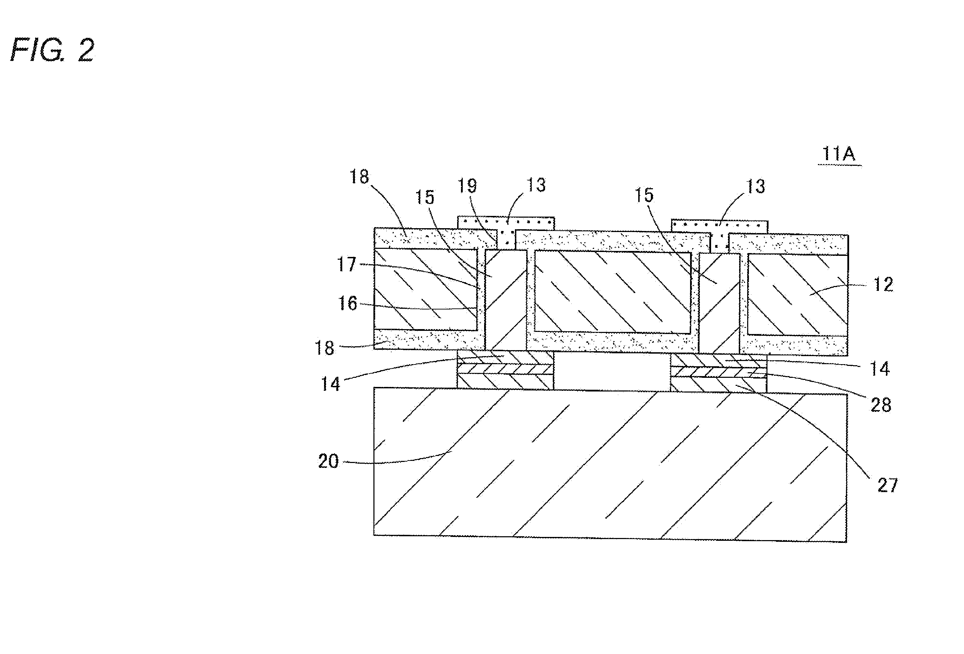

Figs. 1 and 2 are a schematic perspective view and a sectional view illustrating an example of an electrode structure in which the electrode is formed in the end portion of the through-wiring, respectively. In an electrode structure 11A, an electrode 13 is formed in an upper surface of a substrate 12, an electrode 14 is formed in a lower surface of the substrate 12, and the electrodes 13 and 14 located in the upper surface and lower surface of the substrate 12 are electrically connected by a through-electrode 15 piercing the substrate 12.

As illustrated in Figs. 1 and 2, a through-hole 16 is made from the upper surface to the lower surface of the substrate 12, an inner circumferential surface of the through-hole 16 is coated with a borehole insulating film 17, and the through -electrode 15 is made in the through-hole 16 with the borehole insulating film 17 interposed therebetween. The upper surface and lower surface of the substrate 12 is coated with an insulating film 18. The electrode 13 is formed above the insulating film 18 on the upper surface of the substrate 12, and the electrode 13 is connected to an upper end face of the through-electrode 15 through a contact hole 19 of the insulating film 18. The electrode 14 is formed below the insulating film 18 on the lower surface of the substrate 12, and the upper surface of the electrode 14 is connected to the lower surface of the through-etectrode 15. The electrode 14 on the lower surface of the substrate 12 is joined to a pattern wiring 27 of a wiring substrate 20 by a joining material 28 such as solder.

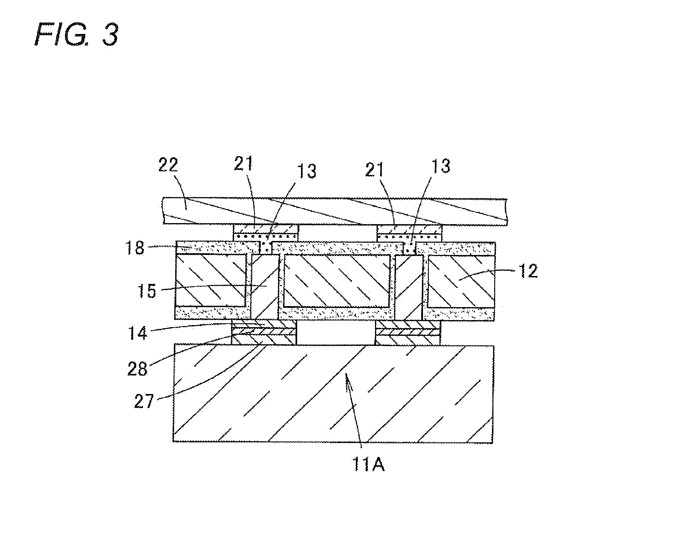

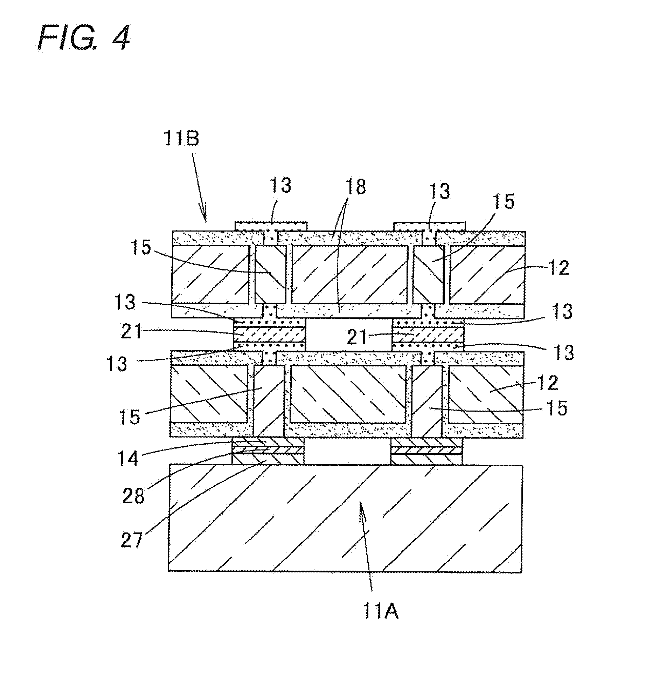

For example, as illustrated in Figs. 3 and 4, in the electrode structure 11A, the electrode 13 is joined to another member. Fig. 3 illustrates the case where the electrode 13 is joined to a wiring pad of a circuit substrate 22 using a joining material 21 such as solder. Fig. 4 illustrates the electrode structure 11A in which the electrodes 13 and 14 formed in both surfaces of the substrate 12 are connected by the through-electrode 15 and an electrode structure 11B in which the electrodes 13 formed in both surfaces of the substrate 12 are connected by the through-electrode 15. In Fig. 4, the electrode 13 of the electrode structure 11A and the electrode 13 of the electrode structure 11B are joined by the joining material 21 to laminate the electrode structures.

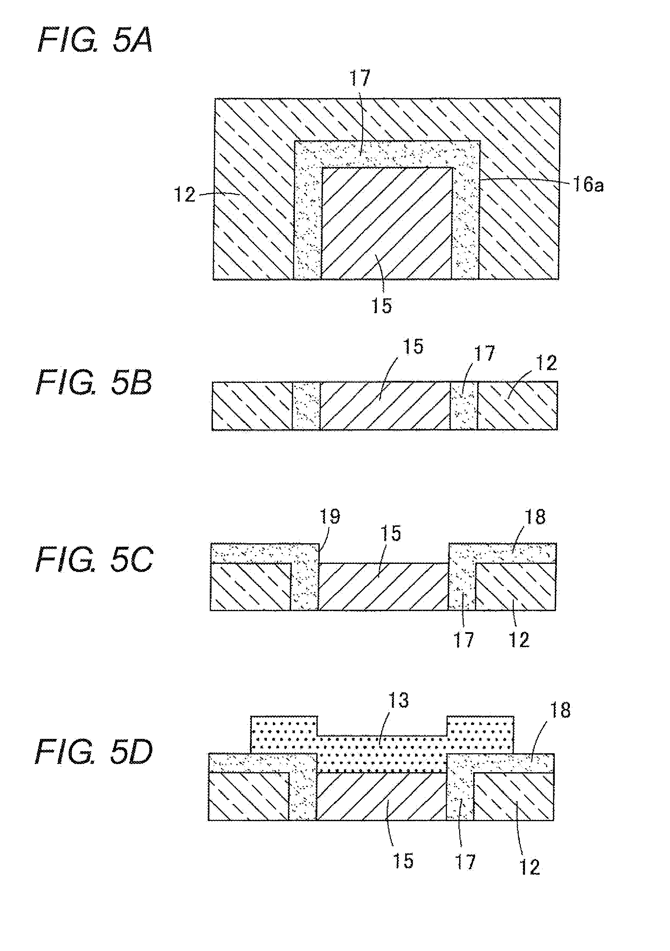

The electrode portion in the electrode structure 11A or 118 is prepared through processes illustrated in Figs. 5A to 5D. As illustrated in Fig. 5A, after a recess 16a is formed in the substrate 12 made of Si or the like, the borehole insulating film 17 made of $SiO_2$ or the like is formed in an inner surface of the recess 16a, and the recess 16a coated with the borehole insulating film 17 is filled with a conductive material to form the through-electrode 15 in the recess 16a.

The through-electrode 15 is exposed by grinding the substrate 12, the upper end face of the through-electrode 15 is polished, and the upper end face of the through-electrode 15 is flattened flush with the upper surface of the substrate 12 as illustrated in Fig. 5B. Then, as illustrated in Fig. 5C, the insulating film 18 made of $SiO_2$ or the like is formed on the upper surface of the substrate 12, and the contact hole 19 is made in the insulating film 18 while aligned with the upper end face of the through-electrode 15. Then, an electrode metal is deposited on the through-electrode 15 and the upper surface of the insulating film 18 by vapor deposition or sputtering, and the electrode 13 and the through-electrode 15 are connected while the electrode metallic layer is patterned to form the electrode 13 as illustrated in Fig. 5D.

In principle, the end face (exposed surface) of the through-electrode 15 is flattened in the process of Fig. 5B. However, from the technical viewpoint, it is actually difficult that a step between the end face of the through-electrode 15 and the surface of the substrate 12 is decreased to the order or less of sub-micrometer to flatten the end face of the through-electrode 15 flush with the surface of the substrate 12.

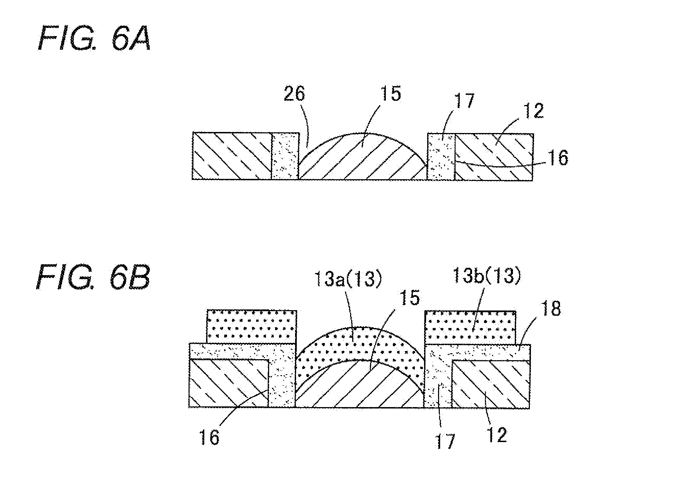

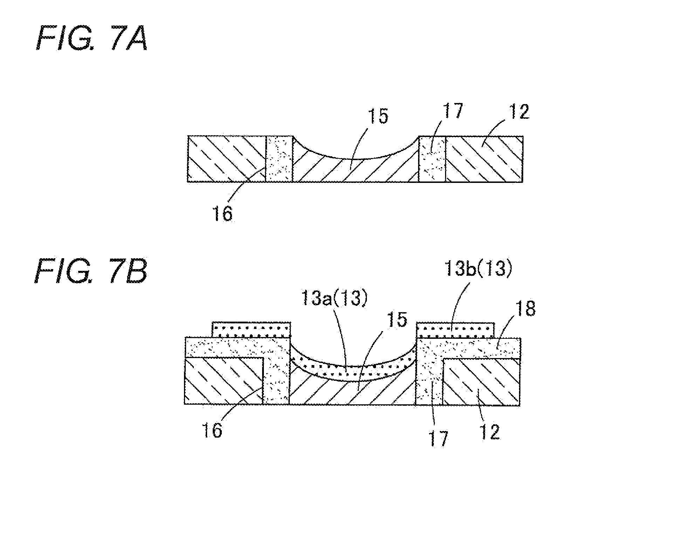

Therefore, when the through-electrode 15 projected from the substrate 12 is flattened flush with the surface of the substrate 12 by chemical mechanical polishing, due to a degree of chemical action and mechanical action in performing the chemical mechanical polishing, occasionally a groove 26 is generated between the through-electrode 15 and the borehole insulating film 17 as illustrated in Fig. 6A, or the end face of the through-electrode 15 is recessed as illustrated in Fig. 7A. When the end face of the through-electrode 15 is flattened in a certain region, due to an in-plane variation during the polishing, the groove 26 is generated between the through-electrode 15 and the borehole insulating film 17 in another region as illustrated in Fig. 6A, or the end face of the through-electrode 15 is recessed as illustrated in Fig. 7A.

Thus, the groove 26 is generated around the through-electrode 15 in the through-hole 16 as illustrated in Fig. 6A. When the insulating film 18 is formed in a region except the through-electrode 15 to form the electrode 13 on the insulating film 18 in the end face of the through-electrode 15 and the surroundings of the through-electrode 15 as illustrated in Fig. 6B, occasionally disconnection of the electrode 13 is generated due to the existence of the groove 26.

When the disconnection is generated between the electrode 13a (13) formed in the end face of the through-electrode 15 and the electrode 13b (13) formed on the insulating film 18, the through-electrode 15 and the circuit substrate 22 are not electrically connected even if the electrode 13b is connected to the circuit substrate 22 as illustrated in Fig. 3, thereby generating a defect.

Further, as described above, the end face of the through-electrode 15 is recessed as illustrated in Fig. 7A. When the insulating film 18 is formed in a region except the through-electrode 15 to form the electrode 13 on the insulating film 18 in the end face of the through-electrode 15 and the surroundings of the through-electrode 15 as illustrated in Fig. 7B, occasionally the disconnection is generated between the electrode 13a (13) formed in the end face of the through-electrode 15 and the electrode 13b (13) formed on the insulating film 18.

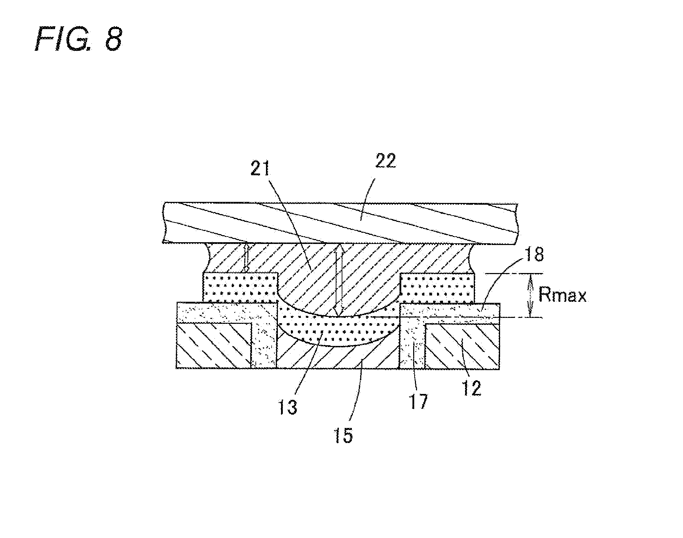

When the electrode 13 is joined to the circuit substrate 22 using the joining material 21 such as solder while the end face of the through-electrode 15 is recessed, a thickness of the joining material 21 is largely changed by location as illustrated in Fig. 8. Therefore, when thermal expansion and contraction are generated by a temperature change, an internal stress generated between the joining material 21 and the circuit substrate 22 or the electrode 13 is increased to easily generate peel-off or a crack in the joined portion, which results in a risk of generating the disconnection between the electrode 13 and the circuit substrate 22.

(Method disclosed in Japanese Unexamined Patent Publication No. 7-283536)

For example, Japanese Unexamined Patent Publication No. 7-283536 discloses a technique of processing the end face of the through-electrode flush with the surface of the substrate. In the processing method disclosed in Japanese Unexamined Patent Publication No. 7-283536, as illustrated in Fig. 9, an abrasive compound 25 that contains colloidal silica having an average abrasive grain diameter of 80 nm or less is applied onto an abrasive cloth 24 bonded onto a surface plate 23, polishing surfaces of the substrate 12 and through-electrode 15 are brought into contact with the abrasive compound 25, and polishing is performed by maintaining a polishing pressure at a predetermined pressure such that a step d between the end face of the through-electrode and the surface of the substrate surface falls within a range of -0.5 $\mu$m $\leq$ d $\leq$ 0.5 $\mu$m.

However, the condition described in Japanese Unexamined Patent Publication No. 7-283536 that the step d between the end face of the through-electrode and the surface of the substrate surface falls within a range of -0.5 $\mu$m $\leq$ d $\leq$ 0.5 $\mu$m in order to prevent the disconnection is just an experimental rule. In particular, when the insulating film 18 is formed on the upper surface of the substrate 12 to form the electrode 13 from above the insulating film 18, depending on a relationship with the thickness of the insulating film 18 or the thickness of the electrode 13, occasionally the disconnection is generated even if the step d between the end face of the through-electrode and the surface of the substrate surface satisfies the condition of -0.5 $\mu$m $\leq$ d $\leq$ 0.5 $\mu$m, and occasionally the disconnection is not generated even if the step d does not satisfy the condition.

When flatness of the substrate and through-electrode is obtained by the method of Japanese Unexamined Patent Publication No. 7-283536, the polishing condition changes depending on the material, the shape, and dimensions of the through-electrode, and time and cost are increased to determine the optimum polishing condition through a trial and error process, which results in a problem in that a development time is lengthened while the cost for the electrode structure is increased.

SUMMARY

The present invention has been devised to solve the problems described above, and an object thereof is to provide a structure that can securely prevent the disconnection in the electrode portion in an electrode portion structure in which the electrode is formed in the end portion of the through-wiring.

In accordance with an aspect of the invention, an electrode portion structure, in which a through-electrode is formed in a through-hole made in a substrate, a surface of the substrate is ground and polished, the surface of the substrate is coated with an insulating film, a contact hole is made in the insulating film while aligned with an end face of the through-electrode, an electrode is formed on the insulating film, and the electrode is formed in an end face of the through-electrode through the contact hole, wherein the end face of the through-electrode is formed so as not to be recessed from the surface of the substrate, and the end face of the through-electrode is formed such that a projection length Dp of the through-electrode, measured from the surface of the substrate at an opening edge of the contact hole, becomes equal to or lower than a thickness Ddiel of the insulating film and, at the same time, the end face of the through-electrode is formed so as to satisfy the following conditional expression:

$$0 \leq \text{Dtsv} \leq \text{Ddiel} + \text{Dp},$$

where Dp>0 and Dtsv is a projection length of an apex of the through-electrode, which is measured from the surface of the substrate.

In the electrode portion structure according to the aspect of the invention, when the thickness of the insulating film is kept constant, the maximum step of the electrode surface can be minimized to improve the flatness of the electrode surface. When the electrode structure including the joined portion is mounted on another circuit substrate, or when a plurality of electrode structures are laminated, the thickness of the joining material can be homogenized in joining the electrode to the electrode pad of the circuit substrate using the joining material such as solder or in joining the electrodes each other. Accordingly, the internal stress generated in the joining material or electrode by the thermal expansion and contraction due to the temperature change can be loosened to prevent the peel-off or crack of the joining material or electrode, and the disconnection can be prevented in the electrode joining portion.

In the electrode portion structure according to the aspect of the invention, preferably a thickness of the electrode is more than a thickness of the insulating film. Accordingly, the disconnection of the electrode is not generated in the step portion of the insulating film.

In the electrode portion structure according to another aspect of the invention, preferably the end face of the through-electrode is formed by a curved surface. Accordingly, because the end face of the through-electrode can be formed into the curved surface, the end face of the through-electrode can be adjusted by polishing the substrate, thereby improving the high-volume production property.

In the electrode portion structure according to still another aspect of the invention, preferably the whole end face of the through-electrode is exposed from the opening of the insulating film. Accordingly, a connection area between the end face of the through-electrode and the electrode can be maximized to reduce a resistance of a connection portion between the through-electrode and the electrode.

In the electrode portion structure according to the aspect of the invention, preferably the opening of the insulating film is formed inside an outer circumference of the through-electrode. Accordingly, the exposure of the substrate from the insulating film due to the variation in making the contact hole can be prevented, and the required accuracy can be loosened in making the contact hole. Additionally, because an upper limit of the projection length Dtsv of the through-electrode can be increased, an allowable range or an adjustable range of the projection length Dtsv of the through-electrode is widened to facilitate the design and production of the electrode portion.

The means for solving the problem in the invention has the feature that the above-described constituents are appropriately combined, and many variations can be made by combining the constituents in the invention.

BRIEF DESCRIPTION OF THE DRAWINGS

Fig. 1 is a schematic perspective view illustrating an example of an electrode structure;
Fig. 2 is a sectional view taken on a line X-X of Fig. 1;
Fig. 3 is a sectional view illustrating a state in which an electrode having an electrode structure of Fig. 2 is joined to a circuit substrate;
Fig. 4 is a sectional view illustrating a state in which one of electrodes having an electrode structure that includes electrodes in both surfaces of the substrate and the electrode having the electrode structure of Fig. 2 are joined to each other;
Figs. 5A to 5D are schematic sectional views illustrating a process of preparing an electrode portion having an electrode structure;
Figs. 6A and 6B are schematic sectional views illustrating the case where a groove is generated around an end face of a through-electrode by polishing;
Figs. 7A and 7B are schematic sectional views illustrating the case where the end face of the through-electrode is recessed into a dish shape by the polishing;
Fig. 8 is a sectional view for explaining a defect when the end face of the through-electrode is recessed as illustrated in Fig. 7B;

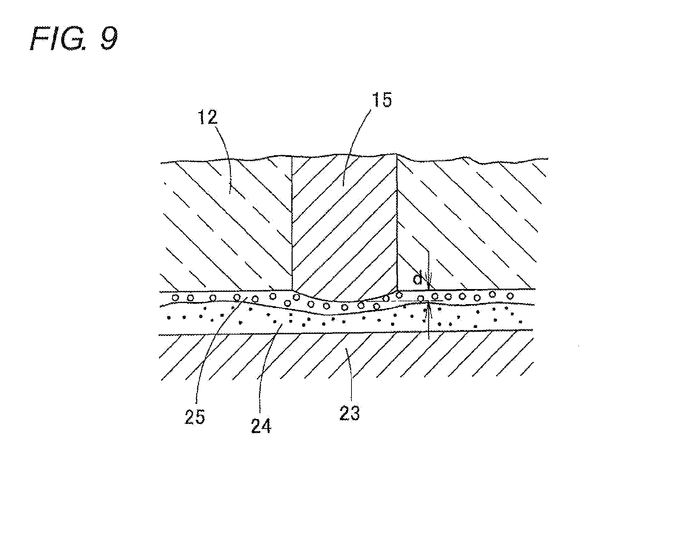

Fig. 9 is a schematic sectional view for explaining a method for polishing a through-electrode disclosed in Japanese Unexamined Patent Publication No. 7-283536;
Fig. 10 is a schematic sectional view illustrating an electrode portion structure according to an embodiment of the invention;
Fig. 11 is a sectional view for explaining a process of producing of the electrode portion of the invention;
Fig. 12 is a sectional view for explaining a process subsequent to the process of Fig. 11;
Fig. 13A is a sectional view for explaining a process subsequent to the process of Fig. 12;
Fig. 13B is a sectional view for explaining a process subsequent to the process of Fig. 13A;
Fig. 14 is a sectional view for explaining a process subsequent to the process of Fig. 13B;

Fig. 15 is a view illustrating one mode (mode I) of the electrode portion;

Fig. 16 is a view illustrating another mode (mode II) of the electrode portion;

Fig. 17 is a view illustrating still another mode (mode III) of the electrode portion;

Fig. 18 is a view illustrating still another mode (mode IV) of the electrode portion;

Fig. 19 is a view illustrating still another mode (mode V) of the electrode portion;

Fig. 20 is a view illustrating still another mode (mode VI) of the electrode portion;

Fig. 21 is a view for explaining a definition of a projection length Dp of a through-electrode at an edge of a contact hole when the edge of the contact hole is inclined;

Fig. 22 is a view illustrating a relationship between a maximum step Rmax in an electrode surface and a projection length Dtsv of a through-electrode; and

Figs, 23A and 23B are schematic sectional views explaining an effect of the invention.

DETAILED DESCRIPTION

Hereinafter, preferred embodiments of the present invention will be described with reference to the drawings. However, the invention is not limited to the following embodiments, but various design changes can be made without departing from the scope of the invention.

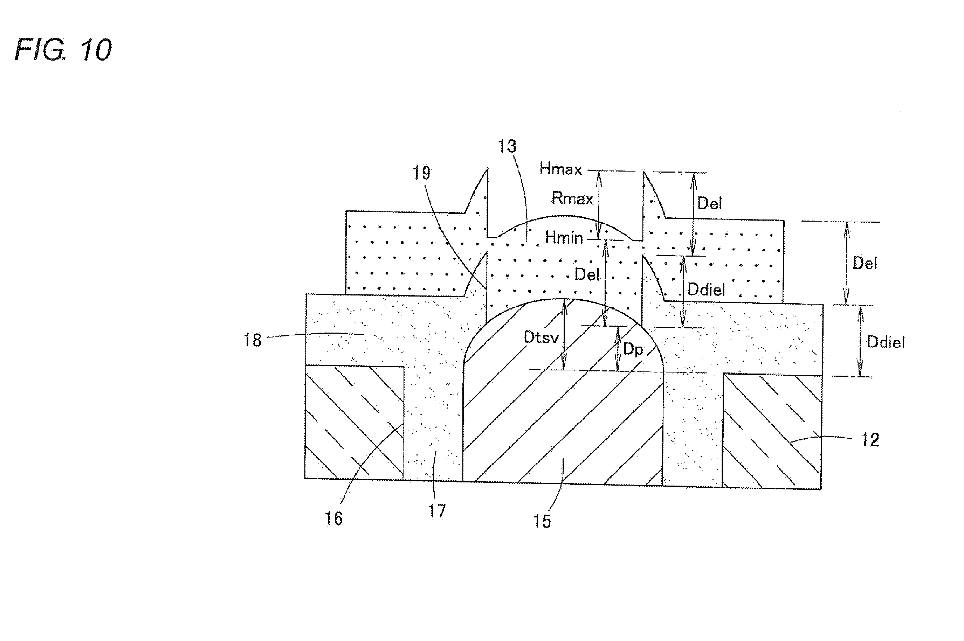

Fig. 10 is an enlarged sectional view illustrating an electrode portion structure according to an embodiment of the invention. For example, the electrode portion structure is used in an electrode structure 11A illustrated in Figs. 1 and 2 and an electrode structure 11B illustrated in Fig. 4. In the electrode portion structure of the embodiment, as illustrated in Fig. 10, a through-hole 16 is made from an upper surface to a lower surface of a substrate 12 made of Si or the like, an inner circumferential surface of the through-hole 16 is coated with a borehole insulating film 17 made of $SiO_2$ or the like, and the through-hole 16 is filled with a conductive material such as Cu and AuSn with the borehole insulating film 17 interposed therebetween, thereby forming a through-electrode 15. Through-wiring includes one in which the borehole insulating film 17 and a barrier metal film such as Ti or a nitride film are formed in a laminated manner between the substrate 12 and the through-electrode 15. An end face (upper surface) of the through-electrode 15 is formed flat so as to be flush with the upper surface of the substrate 12, or the end face becomes a substantially smoothly curved surface while being projected from the upper surface of the substrate 12. The upper surface of the substrate 12 is coated with an insulating film 18 made of $SiO_2$ or the like, and a contact hole 19 is made in the insulating film 18 while aligned with the through-hole 16. An opening diameter of the contact hole 19 may be equal to an inner diameter of the borehole insulating film 17 formed in the inner circumferential surface of the through-hole 16, and an inner circumferential edge of the contact hole 19 may be matched with the inner circumferential surface of the borehole insulating film 17. Alternatively, the opening diameter of the contact hole 19 may be lower than the inner diameter of the borehole insulating film 17 formed in the inner circumferential surface of the through-hole 16, and the insulating film 18 (portion at the edge of the contact hole 19) may be overlapped on the end face of the through-electrode 15. An electrode 13 made of an electrode metal such as Au and Pt is formed on the end face of the through-electrode 15 exposed to the inside of the contact hole 19 and on the insulating film 18 around the through-electrode 15, and the electrode 13 is connected to the end face of the through-electrode 15 through the contact hole 19. An electrode 14 provided on the other end face (lower surface) of the through-electrode 15 is connected to a pattern wiring 27 like the electrode structure 11A illustrated in Figs. 1 and 2 or joined to the electrode 13 like the electrode structure 11B illustrated in Fig. 4.

Assuming that Dtsv is a projection length (maximum projection amount) of an end face apex of the through-electrode 15 based on the upper surface of the substrate 12, Dp is a projection length of the through-electrode 15 at the edge of the contact hole 19 based on the upper surface of the substrate 12, and Ddiel is a thickness of the insulating film 18, the electrode portion structure of the invention is configured to satisfy the following conditions:

$$Dp \leq Ddiel \qquad \text{(condition 1)}$$

and

$$0 \leq Dtsv \leq Ddiel + Dp \qquad \text{(condition 2)}$$

Where Dtsv $\geq$ 0, Dp $\geq$ 0, and Ddiel > 0, the projection length Dtsv and the projection length Dp become Dtsv > 0 and Dp > 0 when the end face of the through-electrode 15 is projected from the upper surface of the substrate 12, and the projection length Dtsv and the projection length Dp become Dtsv < 0 and Dp < 0 when the end face of the through-electrode 15 is recessed from the upper surface of the substrate 12.

The conditions 1 and 2 can be expressed by the following conditional expression:

$$0 \leq Dtsv \leq Ddiel + Dp \leq 2 \times Ddiel$$

A thickness Del of the electrode 13 is more than the thickness Ddiel of the insulating film 18.

$$Del > Ddiel \qquad\qquad (condition\ 3)$$

The through-electrode 15 is polished or the insulating film 18 or the electrode 13 is formed such that the conditions 1 and 2 and the condition 3 are satisfied, which allows the disconnection to be prevented in the electrode 13 and in the periphery of the electrode 13.

(Producing Method)

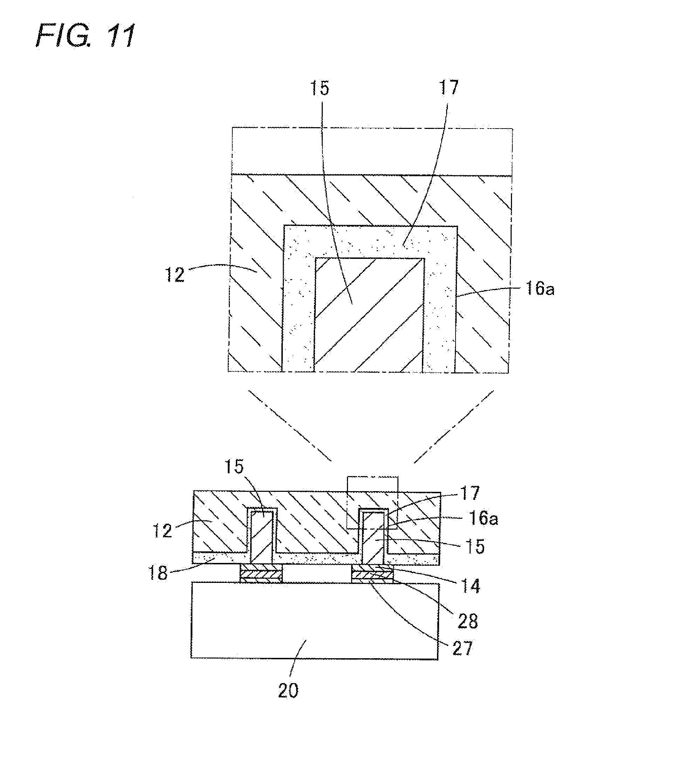

Figs. 11, 12, 13A, 13B, and 14 are schematic sectional views illustrating a process of producing the electrode structure 11A and the electrode portion of the electrode structure 11A. In the process of Fig. 11, in the substrate 12 (for example, an SOI substrate) whose lower surface is coated with the insulating film 18, a recess 16a is formed in the lower surface, and an inner surface of the recess 16a is coated with the borehole insulating film 17 made of $SiO_2$ or the like. The recess 16a coated with the borehole insulating film 17 is subjected to plating or the like to fill the recess 16a with the through-electrode 15 made of the conductive material such as Cu and AuSn. The electrode 14 is provided immediately below the recess 16a, and the upper surface of the electrode 14 is joined to the lower surface of the through-electrode 15. The electrode 14 is joined to the pattern wiring 27 of the wiring substrate 20 by a joining material 28 such as solder.

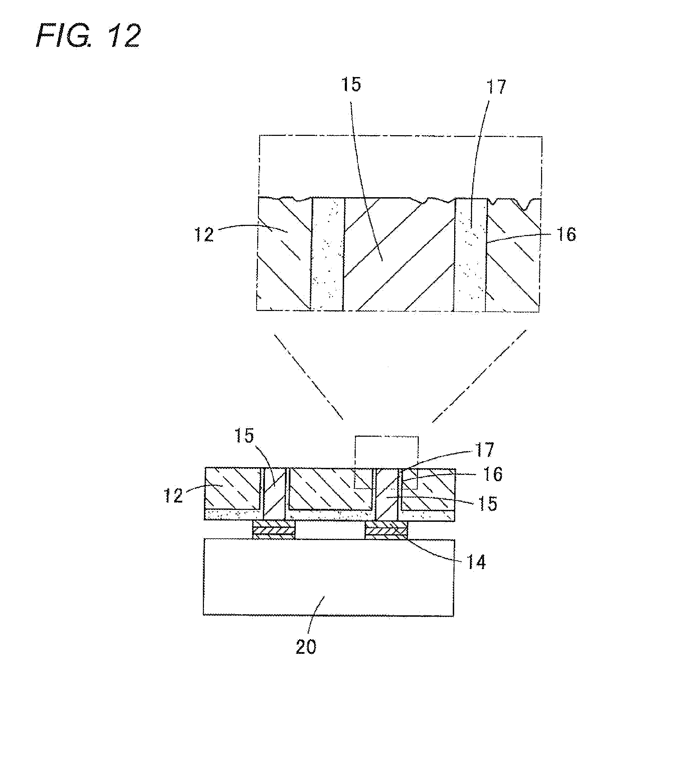

Then, as illustrated in Fig. 12, the upper surface of the substrate 12 is ground until the upper surface of the substrate 12 is exposed from the through-electrode 15. In the grinding process, because high finish accuracy is not required as long as good grinding efficiency is obtained, the upper surface of the substrate 12 may coarsely be ground. As a result, the recess 16a vertically pierces the substrate 12 to constitute the through-hole 16, and the upper end face on the through-electrode 15 is substantially flush with the upper surface of the substrate 12.

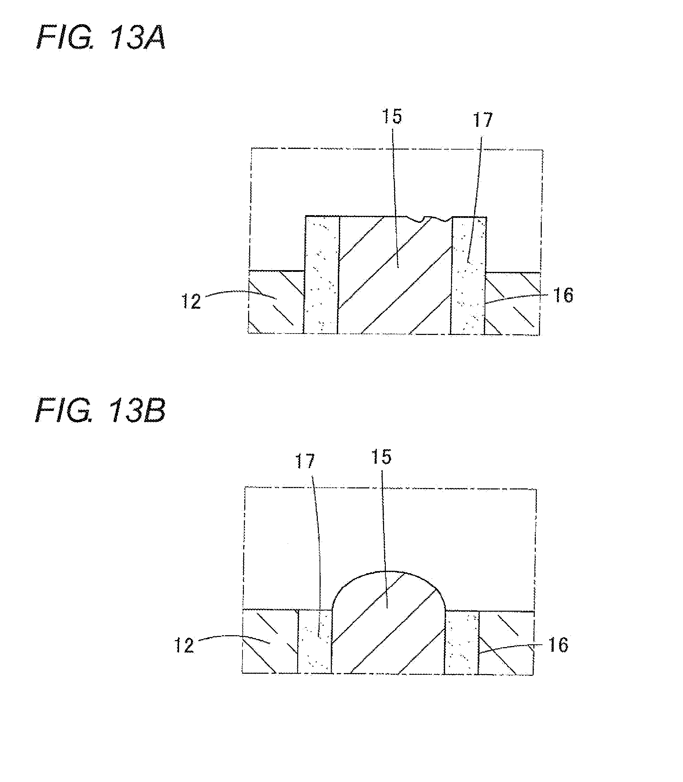

The upper surface of the substrate 12 is polished a plurality of times by Chemical Mechanical Polishing (CMP). In the CMP, because chemical polishing is performed in addition to mechanical polishing, only a specific material in a polishing object containing a plurality of materials can selectively be polished using an abrasive compound suitable to the specific material. Therefore, in a first-stage chemical polishing, the upper surface of the substrate 12 is flatly polished using slurry (abrasive compound) having high polishing performance to the substrate 12. In the first-stage chemical polishing, because a polishing amount of the substrate 12 is more than a polishing amount of the through-electrode 15, an upper end portion of the through-electrode 15 remains without polishing in the polished upper surface of the substrate 12 as illustrated in Fig. 13A, and is projected from the upper surface of the substrate 12, Then, in a second-stage chemical polishing, the upper surface of the substrate 12 is finely polished using slurry (abrasive compound) having high polishing performance to the through-electrode 15. In the second-stage chemical polishing, because the through-electrode 15 projected from the upper surface of the substrate 12 is polished, the end face of the through-electrode 15 projected from the upper surface of the substrate 12 is finished into a smoothly curved surface as illustrated in Fig. 13B. In the second-stage chemical polishing, management is performed such that the end face of the through-electrode 15 is not recessed from the upper surface of the substrate 12, and the polishing process is ended while the end face of the through-electrode 15 is slightly projected from the upper surface of the substrate 12.

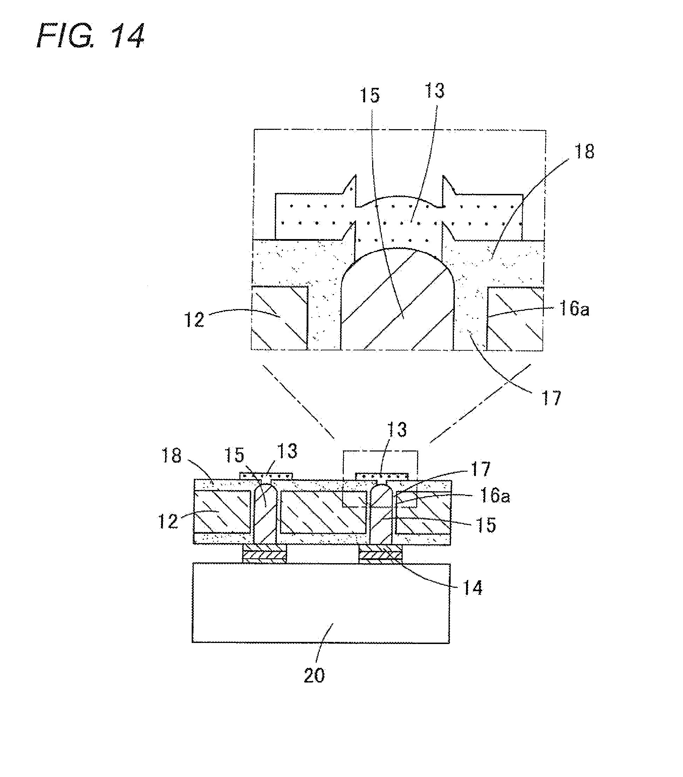

Then, as illustrated in Fig. 14, the insulating film 18 made of $SiO_2$ or the like is formed on the upper surface of the substrate 12, and the contact hole 19 is made in the insulating film 18 at the end face of the through-electrode 15. The contact hole 19 may be made such that the opening diameter of the contact hole 19 is equal to the inner diameter of the borehole insulating film 17. Desirably, the opening diameter of the contact hole 19 is set lower than the inner diameter (a diameter in a horizontal section of the through-electrode 15) of the borehole insulating film 17 such that the end face of the through-electrode 15 is partially coated with the insulating film 18. This is because the upper surface of the substrate 12 is possibly exposed from the insulating film 18 due to a variation or a position deviation of the opening diameter of the contact hole 19 when the opening diameter of the contact hole 19 is equal to the inner diameter of the borehole insulating film 17. Then, the electrode metal such as Au and Pt is deposited on the insulating film 18 by vapor deposition or sputtering, the electrode metallic layer is patterned to form the electrode 13 on the through-electrode 15, and the electrode 13 is connected to the through-electrode 15 through the contact hole 19. Therefore, the electrode portion producing process is completed.

(Principle of the Invention)

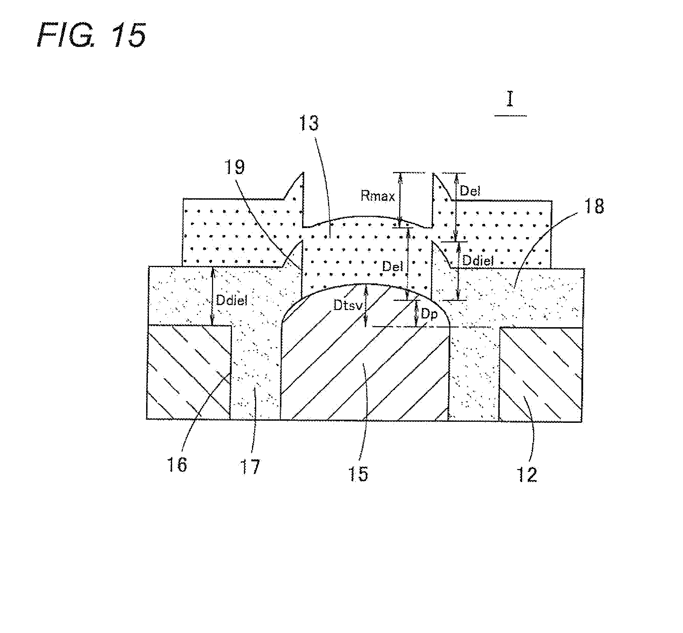

The reasons for the conditions 1 to 3 will be described below. Figs. 15 to 20 illustrate the through-etectrodes 15 having different dimensions while classified. Hereinafter, a maximum step Rmax in the surface of the electrode 13 is evaluated with respect to the electrode portions (modes I to VI). As illustrated in Fig. 10, the symbols used in Figs. 15 to 20 are as follows.
Dtsv: the projection amount (maximum projection length) of the end face apex of the through-electrode 15 based on the upper surface of the substrate 12
Dp: the projection length of the through-electrode 15 at the edge of the contact hole 19 based on the upper surface of the substrate 12
Ddiel the thickness of the insulating film 18
Del: the thickness of the electrode 13
Rmax: the maximum step of the surface of the electrode 13
The maximum step Rmax in the surface of the electrode 13 means a difference Hmax-Hmin between a height (a height vertically measured from the upper surface of the substrate 12) Hmax at the highest point in the surface of the electrode 13 and a height (the height vertically measured from the upper surface of the substrate 12) Hmin at the lowest point in the surface of the electrode 13. The parameters Dtsv, Dp, Hmax, and Hmin are expressed by a positive (+) amount on the outside (in the drawings, an upper side of the substrate upper surface) of the substrate 12 when measured from the upper surface of the substrate 12, and are expressed by a negative (-) amount on the inside (in the drawings, a lower side of the substrate upper surface) of the substrate 12 when measured from the upper surface of the substrate 12. In the process of polishing the through-electrode 15, a relationship of $|Dp| \leq |Dtsv|$ is obtained because the end face of the through-electrode 15 becomes the curved surface.
The mode I illustrated in Fig. 15 will be discussed. In the mode I of Fig. 15, the upper end face of the through-electrode 15 is flush with the upper surface of the substrate 12, or the upper end face of the through-electrode 15 is projected from the upper surface of the substrate 12, and the projection length Dtsv of the through-electrode 15 is equal to or lower than the thickness Ddiel of the insulating film 18. That is, the mode I of Fig. 15 satisfies the following condition:

$$0 \leq Dtsv \leq Ddiel \qquad (condition\ 4)$$

As can be seen from Fig. 15, the following equations are obtained in the mode I:

$$Hmax = Dp + Ddiel + Del$$
$$Hmin = Dp + Del$$

The maximum step Rmax in the surface of the electrode 13 is expressed by the following mathematical formula 1:

$$Rmax = Hmax - Hmin$$

$$= (Dp + Ddiel + Del) - (Dp + Del)$$
$$= Ddiel \qquad (mathematical\ formula\ 1)$$

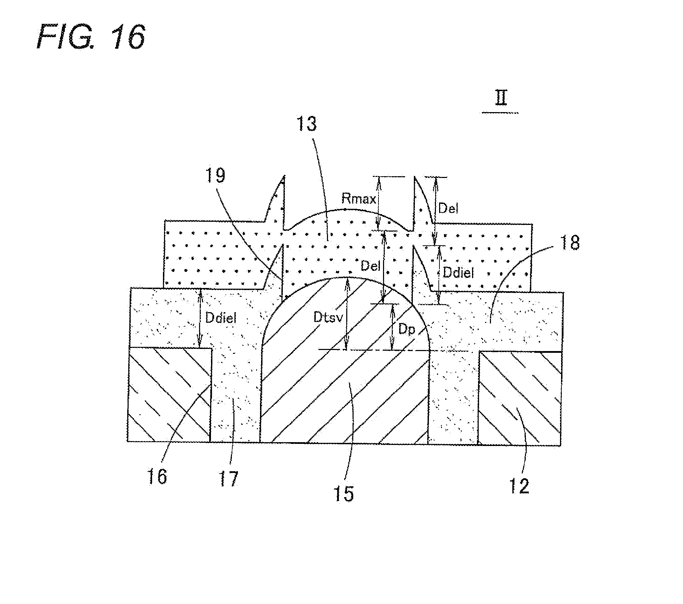

Therefore, for the mode I, the maximum step Rmax in the surface of the electrode 13 becomes a constant value (Ddiel) irrespective of the projection length Dtsv of the through-electrode 15.
In the mode II of Fig. 16, the projection length Dtsv of the through-electrode 15 is equal to or more than the thickness Ddiel of the insulating film 18, and the projection length Dtsv of the through-electrode 15 is equal to or lower than the apex height (Dp + Ddiel) of the insulating film 18, which is measured from the upper surface of the substrate 12 at the edge of the contact hole 19. Further, in the mode II of Fig. 16, the projection length Dp of the through-electrode 15 at the edge of the contact hole 19 is equal to or lower than the thickness Ddiel of the insulating film 18. That is, the mode II of Fig. 16 satisfies the following condition:

$$Ddiel \leq Dtsv \leq Ddiel + Dp \text{ and } Dp \leq Ddiel \qquad \text{(condition 5)}$$

In the mode II, as can be seen from Fig. 16, the following equations are obtained because the step of the electrode 13 at the edge of the contact hole 19 becomes the maximum step Rmax:

$$Rmax = (Dp + Ddiel + Del) - (Dp + Del)$$
$$= Ddiel \qquad \text{(mathematical formula 2)}$$

Therefore, for the mode II, the maximum step Rmax in the surface of the electrode 13 becomes the constant value (Ddiel) irrespective of the projection length Dtsv of the through-electrode 15.

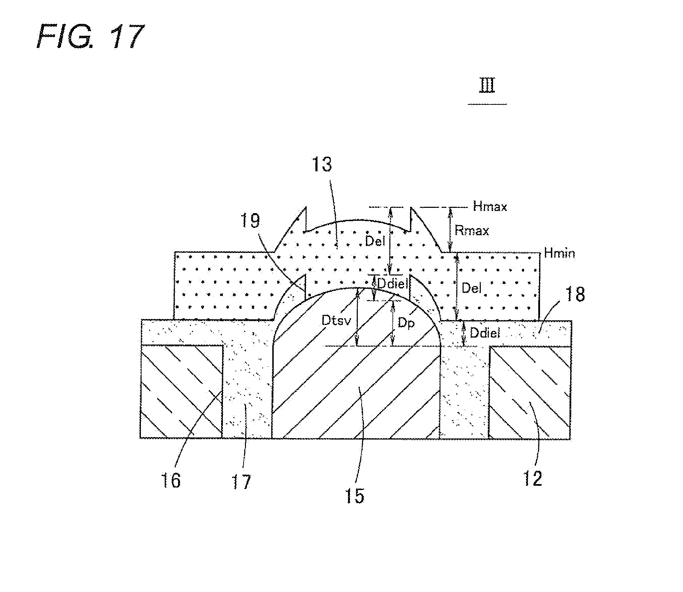

In the mode III of Fig. 17, similarly to the mode II of Fig. 16, the projection length Dtsv of the through-electrode 15 is equal to or more than the thickness Ddiel of the insulating film 18, and the projection length Dtsv of the through-electrode 15 is equal to or lower than the apex height (Dp + Ddiel) of the insulating film 18, which is measured from the upper surface of the substrate 12 at the edge of the contact hole 19. However, in the mode III, the projection length Dp of the through-electrode 15 at the edge of the contact hole 19 is more than the thickness Ddiel of the insulating film 18. That is, the mode III of Fig. 17 satisfies the following condition:

$$Ddiel \leq Dtsv \leq Ddiel + Dp \text{ and } Dp > Ddiel \qquad \text{(condition 6)}$$

The mode III of Fig. 17 is generated, when the projection length Dp of the through-electrode 15 at the edge of the contact hole 19 is more than that of the mode II of Fig. 16, or when the thickness Ddiel of the insulating film 18 is lower than that of the mode II of Fig. 16.

For the mode III, as can be seen from Fig. 17, the apex height of the electrode 13, measured from the upper surface of the substrate 12 at the edge of the contact hole 19, becomes the maximum height Hmax, and the surface height in the flat region of the electrode 13, measured from the upper surface of the substrate 12, becomes the minimum height Hmin. Therefore, the following equations are obtained:

$$Hmax = Dp + Ddiel + Del$$
$$Hmin = Ddiel + De1$$

The maximum step of the electrode 13 becomes as follows:

$$Rmax = Hmax - Hmin$$
$$= (Dp + Ddiel + Del) - (Ddiel + Del)$$
$$= Dp \qquad \text{(condition 3)}$$

Accordingly, for the mode III, the projection length Dp is increased with increasing projection length Dtsv of the through-electrode 15, and therefore the maximum step Rmax is also increased.

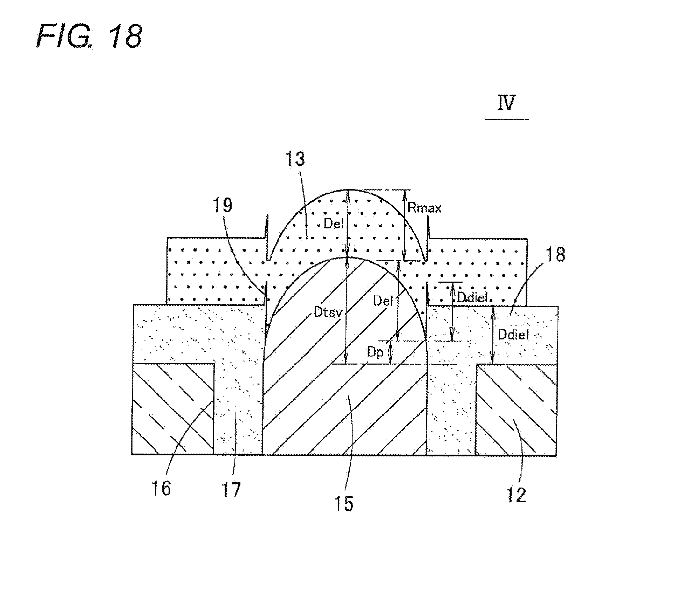

In the mode IV of Fig. 18, the projection length Dtsv of the through-electrode 15 is equal to or more than the apex height (Dp + Ddiel) of the insulating film 18, measured from the upper surface of the substrate 12 at the edge of the contact hole 19. Further, in the mode IV of Fig. 18, the projection length Dp of the through-electrode 15 at the edge of the contact hole 19 is equal to or lower than the thickness Ddiel of the insulating film 18. That is, the mode IV of Fig. 18 satisfies the following condition:

$$Ddiel + Dp \leq Dtsv \text{ and } Dp \leq Ddiel \qquad (condition\ 7)$$

For the mode IV, as can be seen from Fig. 18, the surface height of the electrode 13, measured from the upper surface of the substrate 12 in the center of the through-electrode 15, becomes the maximum height Hmax, and a height of a valley portion of the electrode 13, measured from the upper surface of the substrate 12 at the edge of the contact hole 19, becomes the minimum height Hmin. Therefore, the following equations are obtained:

$$Hmax = Dtsv + Del$$

$$Hmin = Dp + Del$$

The maximum step of the electrode 13 becomes as follows:

$$Rmax = (Dtsv + Del) - (Dp + Del)$$

$$= Dtsv - Dp \qquad (mathematical\ formula\ 4)$$

Accordingly, for the mode IV, Dtsv - Dp is increased with increasing projection length Dtsv of the through-electrode 15, and therefore the maximum step Rmax is also increased.

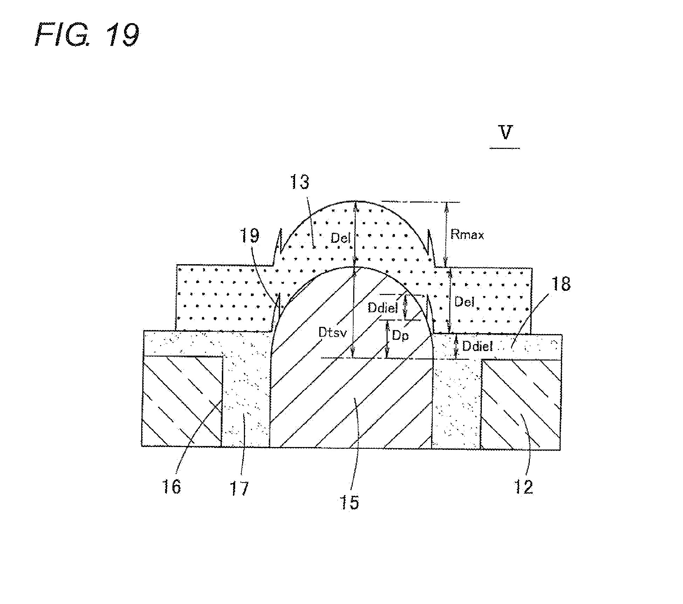

In the mode V of Fig. 19, the projection length Dtsv of the through-electrode 15 is equal to or more than the apex height (Dp + Ddiel) of the insulating film 18, measured from the upper surface of the substrate 12 at the edge of the contact hole 19. However, in the mode V of Fig. 19, the projection length Dp of the through -electrode 15 at the edge of the contact hole 19 is equal to or more than the thickness Ddiel of the insulating film 18. That is, the mode V of Fig. 19 satisfies the following condition:

$$Ddiel + Dp \leq Dtsv \text{ and } Dp > Ddiel \qquad (condition\ 8)$$

For the mode V, as can be seen from Fig. 19, the surface height (Ddiel + Del) of the electrode 13, measured from the upper surface of the substrate 12 in the center of the through-electrode 15, becomes the maximum height Hmax, and the surface height (Ddiel + Del) in the flat region of the electrode 13, measured from the upper surface of the substrate 12, becomes the minimum height Hmin. Therefore, the maximum step of the electrode 13 becomes as follows:

$$Rmax = (Dtsv + Del) - (Ddiel + Del)$$

$$= Dtsv - Ddiel \qquad (mathematical\ formula\ 5)$$

Accordingly, for the mode V, the maximum step Rmax is increased with increasing projection length Dtsv of the through-electrode 15.

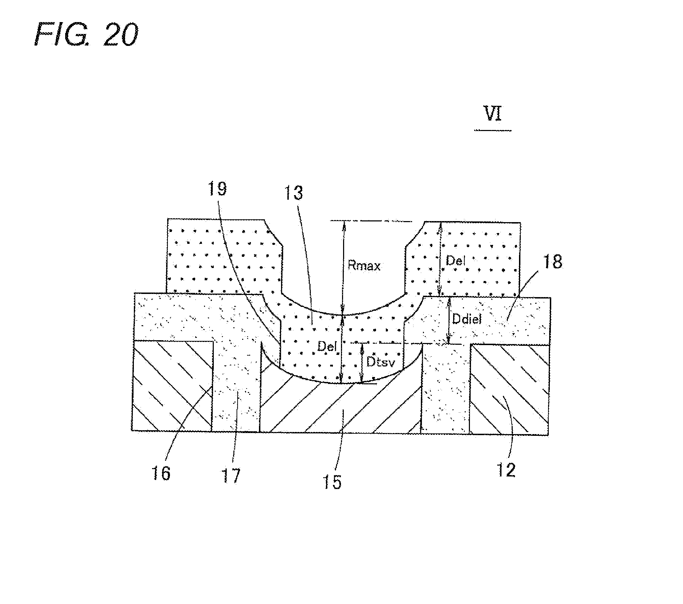

In the mode VI of Fig. 20, the end face of the through-electrode 15 is recessed from the upper surface of the substrate 12. That is, the mode VI of Fig. 20 satisfies the following condition:

$$Dtsv < 0 \qquad (condition\ 9)$$

For the mode VI, as can be seen from Fig. 20, the maximum step Rmax in the surface of the electrode 13 is expressed by the following mathematical formula 6:

$$Rmax = (Ddiel + Del) - (Del + Dtsv)$$
$$= Ddiel - Dtsv \qquad (\text{mathematical formula 6})$$

Accordingly, for the mode IV, the maximum step Rmax in the surface of the electrode 13 is increased with increasing recess (-Dtsv) of the through-electrode 15.

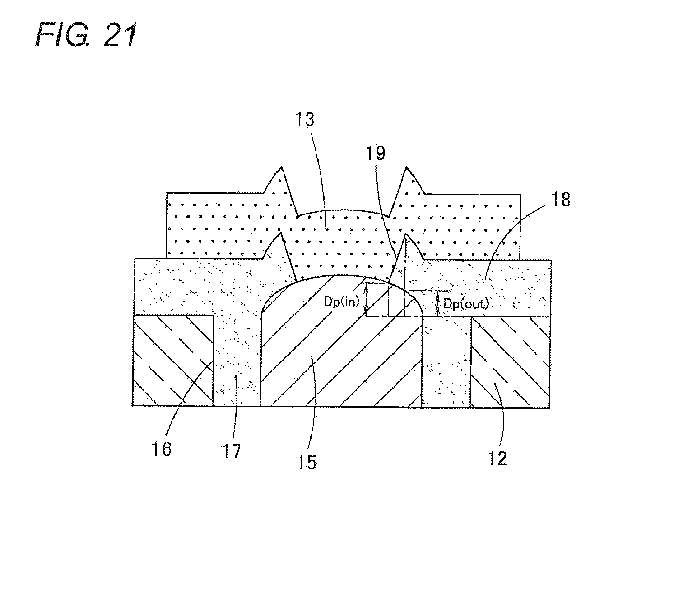

When the contact hole 19 is made in the insulating film 18, actually the edge (inner circumferential surface) of the contact hole 19 is not vertically formed, but the edge of the contact hole 19 tends to be inclined such that the contact hole 19 is spread on the opening side (upper side in Figs. 15 to 20) as illustrated in Fig. 21. In such cases, because the edge of the contact hole 19 is horizontally spread, the position at which the projection length Dp of the through-electrode 15 is determined at the edge of the contact hole 19 based on the upper surface of the substrate 12 becomes ambiguous.

General, even if the projection length Dp is determined at the lower end of the contact hole 19 or the upper end of the contact hole 19, the projection length Dp is substantially kept constant. When the projection length Dp becomes troublesome, the projection length Dp may be determined as illustrated in Fig. 21. When the projection length Dp is used to calculate the maximum height Hmax in the surface of the electrode 13, the highest position at the edge of the contact hole 19, that is, the projection length Dp (out) of the through-electrode 15, located immediately below the upper end at the edge of the contact hole 19, may be used as the value of Dp. When the projection length Dp is used to calculate the minimum height Hmin in the surface of the electrode 13, the lowest position at the edge of the contact hole 19, that is, the projection length Dp (in) of the through-electrode 15, located immediately below the lower end at the edge of the contact hole 19, may be used as the value of Dp.

The values of the maximum step Rmax in the surface of the electrode 13, determined with respect to the modes I to VI, and the conditions are summarized in TABLE 1.

[TABLE 1]

|  | For Dp ≤ Ddiel | For Dp >Ddiel |
|---|---|---|
| Dtsv ≤ 0 | (VI) Rmax = Ddiel - Dtsv | |
| 0 ≤ Dtsv μ ≤ Ddiel | (I) Rmax = Ddiel | - |
| Ddiel ≤ Dtsv < Ddiel + Dp | (II) Rmax = Ddiel | (III) Rmax = Dp |
| Ddiel + Dp ≤ Dtsv | (IV) Rmax = Dtsv - Dp | (V) Rmax = Dtsv -Ddiel |

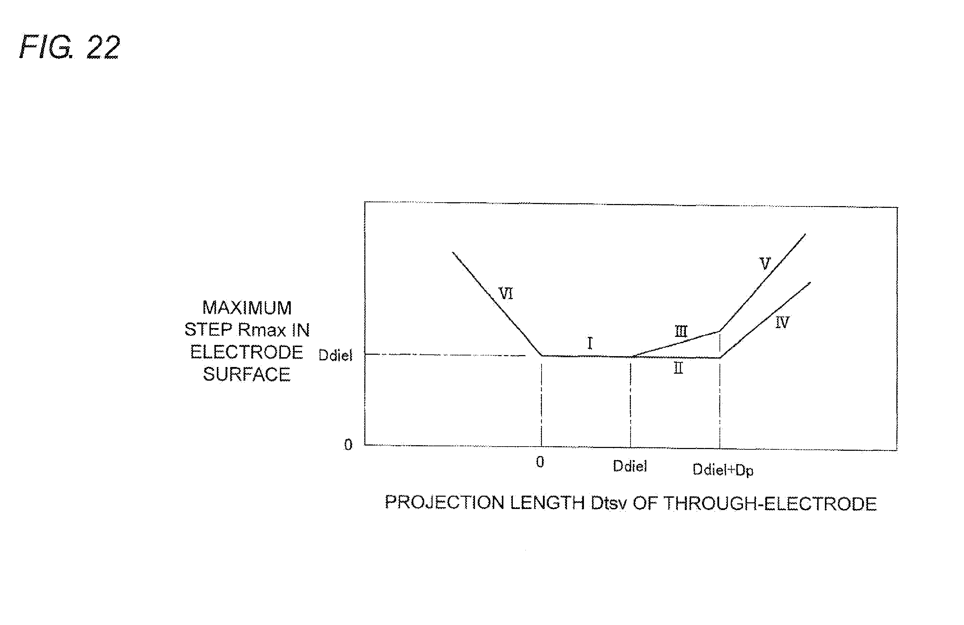

Fig. 22 illustrates a graph in which the maximum step Rmax is expressed as a function of the projection length Dtsv of the through-electrode 15. In Fig. 22, a vertical axis indicates the maximum step Rmax in the surface of the electrode 13, and a horizontal axis indicates the projection length Dtsv of the through-electrode 15. Line segments I to VI of the graph illustrated in Fig. 22 correspond to the modes I to VI, respectively.

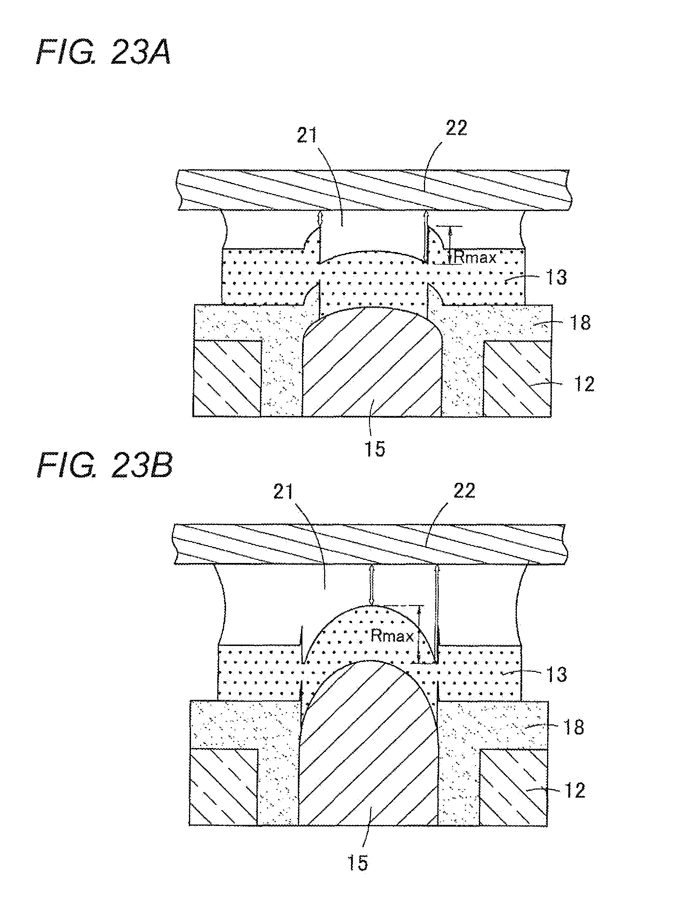

Figs. 23A and 23B illustrate the state in which the electrode 13 is joined to a circuit substrate 22 by a joining material 21 such as solder. Fig. 23A illustrates the electrode portion having the relatively small maximum step Rmax in the surface of the electrode 13, and Fig. 23B illustrates the electrode portion having the relatively large maximum step Rmax in the surface of the electrode 13. For the relatively large maximum step Rmax illustrated in Fig. 23B, a variation (unevenness) of the thickness of the joining material 21 is increased when the electrode 13 is joined to the circuit substrate 22 by the joining material 21. Therefore, when thermal expansion and contraction are generated in the joining material 21 due to a temperature change and the like, an internal stress generated between the joining material 21 and the circuit substrate 22 or between the joining material 21 and the electrode 13 is increased while becoming unevenness, the peel-off or crack is generated to easily generate the disconnection in the joined portion. Particularly, when the end face of the through-electrode 15 is recessed (mode VI), the variation of the thickness of the joining material 21 is extremely increased (see also Fig. 8) to easily generate the peel-off or crack in the joining material 21. On the other hand, for the relatively small maximum step Rmax illustrated in Fig. 23A, the variation of the thickness of the joining material 21 is decreased when the electrode 13 is joined to the circuit substrate 22 by the joining material 21. Therefore, when the thermal expansion and contraction are generated in the joining material 21 due to the temperature change and the like, the internal stress generated between the joining material 21 and the circuit substrate 22 or between the joining material 21 and the electrode 13 is decreased, the peel-off or crack is hardly generated in this joined portion, and the generation of the disconnection can be prevented in the joined portion. Accordingly, when the electrode 13 is joined to the electrode pad that is no another member to mount the electrode structure on the circuit substrate, or when the electrodes 13 are joined to each other to laminate the electrode structures, in order that the generation of the peel-off or crack is suppressed in the joined portion to stabilize mechanical strength or electric properties of the joined portion, desirably the maximum step Rmax in the surface of the electrode 13 is minimized, and the electrode 13 is flattened to homogenize the mounting profile.

As can be seen from Fig. 22, the maximum step Rmax becomes the minimum value Ddiel for the line segments I and II (modes I and II). That is, the projection length Dtsv of the through-electrode 15 is set as follows:

$$0 \leq Dtsv \leq Ddiel \qquad \text{(the condition 4)}$$

or the projection length Dtsv of the through-electrode 15 is set as follows:

$$Dp \leq Ddiel \text{ and } Ddiel \leq Dtsv \leq Ddiel + Dp \quad \text{(the condition 5)}$$

Therefore, the maximum step Rmax in the end face of the through-electrode 15 can be minimized.

Because it can be assumed that $Dp \leq Dtsv$ holds for the through-electrode 15, obviously $Dp (\leq Dtsv) \leq Ddiel$ obtained when the condition 4 is satisfied. Accordingly, the condition 4 or 5 can also be expressed as follows:

$$Dp \leq Ddiel$$

and

$$0 \leq Dtsv \leq Ddiel + Dp$$

These are the conditions 1 and 2.

When the thickness Ddiel of the insulating film 18 is previously determined, the through-electrode 15 is polished such that the projection length Dtsv falls within the range where the condition 4 or 5 is satisfies. When the contact hole 19 is made in the insulating film 18, the maximum step Rmax can be minimized to form the substantially flat electrode 13. Accordingly, when the electrode 13 is joined by the joining material 21, the peel-off or crack is hardly generated, and the disconnection is hardly generated.

The opening diameter of the contact hole 19 may be equal to the outer diameter of the through-electrode 15. However, when the opening diameter of the contact hole 19 is equal to the outer diameter of the through-electrode 15, as described above, possibly the substrate 12 is exposed from the insulating film 18 due to the deviation of the opening position of the contact hole 19 or the variation of the opening diameter of the contact hole 19. On the other hand, when the opening diameter of the contact hole 19 is set lower than the outer diameter of the through-electrode 15 to coat the surroundings of the end face of the through-electrode 15 with the insulating film 18, the exposure of the substrate 12 due to the variation in opening the contact hole 19 is eliminated, and the required accuracy can be loosened in opening the contact hole 19. When the through-electrode 15 is projected, the projection length Dp( > 0) is gradually increased with decreasing opening diameter of the contact hole 19. Therefore, an upper limit (Ddiel + Dp) of the projection length Dtsv of the through-electrode 15 is increased to widen an allowable range of the projection length Dtsv of the through-electrode 15, which facilitates the design and production of the electrode portion.

In the process of polishing the through-electrode 15, the through-electrode 15 may be polished such that the end face of the through-electrode 15 becomes flat. However, when the through-electrode 15 is polished such that the end face of the through-electrode 15 becomes flat, the groove 26 is generated around the through-electrode 15 as illustrated in Figs. 6 and 7, or possibly the end face of the through-electrode 15 is recessed because the chemical action extremely strong during the CMP. Accordingly, preferably a target value of the projection length Dtsv during the polishing of the through-electrode 15 is set as follows:

$$0.1 \ \mu m \leq Dtsv$$

**Claims**

1. An electrode portion structure (11A,11B), in which a through-electrode (15) is formed in a through-hole (16) made in a substrate (12), a surface of the substrate (12) is ground and polished, the surface of the substrate (12) is coated with an insulating film (18), a contact hole (19) is made in the insulating film (18) while aligned with an end face of the through-electrode (15), an electrode (13) is formed on the insulating film (18), and the electrode (13) is formed in an end face of the through-electrode (15) through the contact hole (19),

   the electrode portion structure (11A,11B) being **characterized in that** the end face of the through-electrode (15) is formed so as not to be recessed from the surface of the substrate (12), and

   the end face of the through-electrode (15) is formed such that a projection length Dp of the through-electrode (15), measured from the surface of the substrate (12) at an opening edge of the contact hole (19), becomes equal to or lower than a thickness Ddiel of the insulating film (18) and, at the same time, the end face of the through-electrode (15) is formed so as to satisfy the following conditional expression:

$$0 \le Dtsv \le Ddiel + Dp,$$

   where Dp>0 and Dtsv is a projection length of an apex of the through-electrode (15), which is measured from the surface of the substrate (12).

2. The electrode portion structure (11A,11B) according to claim 1, **characterized in that** a thickness of the electrode (13) is more than a thickness of the insulating film (18).

3. The electrode portion structure according to claim 1, **characterized in that** the end face of the through-electrode (15) is formed by a curved surface.

4. The electrode portion structure (11A,11B) according to claim 1, **characterized in that** the whole end face of the through-electrode (15) is exposed from the contact hole (19) of the insulating film (18).

5. The electrode portion structure (11A,11B) according to claim 1, **characterized in that** the contact hole (19) of the insulating film (18) is formed inside an outer circumference of the through-electrode (15).

## FIG. 1

FIG. 2

## FIG. 3

# FIG. 4

*FIG. 5A*

*FIG. 5B*

*FIG. 5C*

*FIG. 5D*

*FIG. 6A*

*FIG. 6B*

FIG. 7A

15  17  12

16

FIG. 7B

13b(13)

13a(13)  15  18

16  17  12

FIG. 8

FIG. 9

FIG. 10

EP 2 365 742 A1

## FIG. 11

## FIG. 12

*FIG. 13A*

*FIG. 13B*

FIG. 14

FIG. 15

*FIG. 16*

FIG. 17

III

FIG. 18

# FIG. 19

## FIG. 20

VI

FIG. 21

*FIG. 22*

MAXIMUM
STEP Rmax IN
ELECTRODE
SURFACE

PROJECTION LENGTH Dtsv OF THROUGH-ELECTRODE

FIG. 23A

FIG. 23B

Europäisches
Patentamt

European
Patent Office

Office européen
des brevets

# EUROPEAN SEARCH REPORT

**Application Number**

EP 10 18 9078

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JP 7 283536 A (HITACHI LTD) 27 October 1995 (1995-10-27) * abstract * ----- | 1-5 | INV. H05K3/40 |
| A | JP 2004 363275 A (HITACHI METALS LTD) 24 December 2004 (2004-12-24) * abstract * ----- | 1-5 | |

**TECHNICAL FIELDS SEARCHED (IPC)**

H05K

The present search report has been drawn up for all claims

| Place of search | Date of completion of the search | Examiner |
|---|---|---|
| Munich | 9 February 2011 | Poth, Hartwig |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT**
**ON EUROPEAN PATENT APPLICATION NO.**               EP 10 18 9078

This annex lists the patent family members relating to the patent documents cited in the above-mentioned European search report.
The members are as contained in the European Patent Office EDP file on
The European Patent Office is in no way liable for these particulars which are merely given for the purpose of information.

09-02-2011

| Patent document cited in search report | | Publication date | Patent family member(s) | | Publication date |
|---|---|---|---|---|---|
| JP 7283536 | A | 27-10-1995 | NONE | | |
| JP 2004363275 | A | 24-12-2004 | JP | 3627932 B2 | 09-03-2005 |

For more details about this annex : see Official Journal of the European Patent Office, No. 12/82

**EP 2 365 742 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 7283536 A